# EUROPEAN PATENT APPLICATION

(11) **EP 4 613 910 A1**
(43) Date of publication of application: **10.09.2025**
(21) Application number: 23885099.4
(22) Date of filing: 03.11.2023
(51) Int. Cl.: C23C 16/455

(54) **ATOMIC LAYER DEPOSITION APPARATUS**

(30) Priority: 03.11.2022 CN 202211369288
(71) Applicant: Jiangsu Leadmicro Nano-Technology Co., Ltd., Wuxi, Jiangsu 214028 (CN)
(72) Inventor: LI, Wei Min, Wuxi, Jiangsu 214028 (CN); ZHI, Shunhua, Wuxi, Jiangsu 214028 (CN); QIAN, Yiping, Wuxi, Jiangsu 214028 (CN); XU, Suochang, Wuxi, Jiangsu 214028 (CN); WU, Biao, Wuxi, Jiangsu 214028 (CN); ZHOU, Ren, Wuxi, Jiangsu 214028 (CN)
(74) Representative: Novagraaf Technologies
(86) International application number: PCT/CN2023/129610
(87) International publication number: WO 2024/094175

(57) **Abstract**

Embodiments of the present application relate to an atomic layer deposition device. The atomic layer deposition device includes a transition chamber, a diffusion chamber, and one or more air exhaust structures. The transition chamber has an air inlet to receive a gas. The diffusion chamber extends from a first end to a second end, wherein a width of the first end is less than a width of the second end in a radial direction, and the diffusion chamber is in communication with the transition chamber, and the diffusion chamber is configured to accommodate a to-be-deposited semiconductor wafer. The one or more air exhaust structures are in communication with the diffusion chamber. Compared with the prior art, in the atomic layer deposition device, the chamber structure and a source feeding manner of the deposition device are improved, thereby reducing time for each cycle of a deposition process, and improving deposition efficiency.

## Description

### BACKGROUND OF THE INVENTION

### 1. Field of the Invention

The present invention generally relates to technical field of semiconductor manufacturing, and in particular, to an atomic layer deposition device.

### 2. Description of the Related Art

Atomic layer deposition is a thin-film deposition and growth technique in a self-limiting manner by alternately introducing gas-phase reactants into a chamber and performing alternating surface saturation reactions. The atomic layer deposition has advantages such as high bonding strength, good film uniformity, and good composition uniformity, and has been widely applied to many fields such as microelectronic systems, memory dielectric layers, and optical thin films.

Plasma enhanced atomic layer deposition expands the selection range of precursor sources for ordinary atomic layer deposition systems, increases a thin film deposition rate, and reduces the deposition temperature, and therefore may be widely used to deposit thin films on temperature-sensitive materials and flexible substrates. Therefore, plasma enhanced atomic layer deposition is a desirable supplement to the atomic layer deposition.

However, to meet a requirement of plasma energy uniformity, the volume of a plasma enhanced atomic layer deposition chamber is generally designed to be relatively large, which results in a relatively long time for each cycle of an atomic layer deposition process and low deposition efficiency, and therefore severely restricts the production capacity of the atomic layer deposition in industrial applications.

Therefore, an atomic layer deposition device of the prior art needs to be improved, to resolve the problems existing in the prior art.

### SUMMARY OF THE INVENTION

An objective of this application is to provide an atomic layer deposition device, which resolves problems such as a relatively long time for each cycle of a deposition process and low deposition efficiency.

According to an embodiment of this application, an atomic layer deposition device is provided. The atomic layer deposition device includes a transition chamber, a diffusion chamber, and one or more air exhaust structures. The transition chamber has an air inlet to receive a gas. The diffusion chamber extends from the first end to the second end, a width of the first end is less than a width of the second end in a radial direction, and the diffusion chamber is in communication with the transition chamber, and is configured to accommodate a to-be-deposited semiconductor wafer. The one or more air exhaust structures are in communication with the diffusion chamber.

Compared with the prior art, in the atomic layer deposition device provided in this application, a chamber structure and a source feeding manner of a deposition device are improved, thereby reducing time for each cycle of a deposition process, and improving deposition efficiency. In addition, the deposition device provided in this application may be used for both plasma enhanced atomic layer deposition and atomic layer deposition.

### BRIEF DESCRIPTION OF THE DRAWINGS

Accompanying drawings that are necessary for describing embodiments of this application or the prior art are briefly described below to facilitate the description of the embodiments of this application. Apparently, the accompanying drawings in the following description are merely some embodiments of this application. A person skilled in the art may still obtain accompanying drawings of other embodiments based on illustrations in the accompanying drawings without creative efforts.
FIG. 1 is a schematic structural diagram of an atomic layer deposition device according to an embodiment of this application.
FIG. 2A to FIG. 2B are schematic structural diagrams of two spray components according to an embodiment of this application.
FIG. 3 is a schematic structural diagram of a ring-shaped source feeding structure according to an embodiment of this application.
FIG. 4 is an enlarged schematic diagram of a structure A shown in FIG. 1.
FIG. 5 is a schematic structural diagram of another ring-shaped source feeding structure according to n embodiment of this application.
FIG. 6 is a schematic cross-sectional view of a partial structure of the atomic layer deposition device shown in FIG. 1.
FIG. 7 is an enlarged schematic diagram of a structure B shown in FIG. 6.
FIG. 8 is a schematic cross-sectional view of a partial structure of an atomic layer deposition device having two ring-shaped source feeding structures.
FIG. 9 is a schematic structural diagram of another atomic layer deposition device according to an embodiment of this application.

### PREFERRED EMBODIMENT OF THE PRESENT INVENTION

To better understand the spirit of this application, this application is further described below based on some preferred embodiments of this application.

Various implementations of this application are discussed in detail below. Although specific implementation is discussed, it should be understood that the implementations are used for illustration purposes only. A person skilled in the related art is to realize that another component and configuration may be used without departing from the spirit and the protection scope of this application.

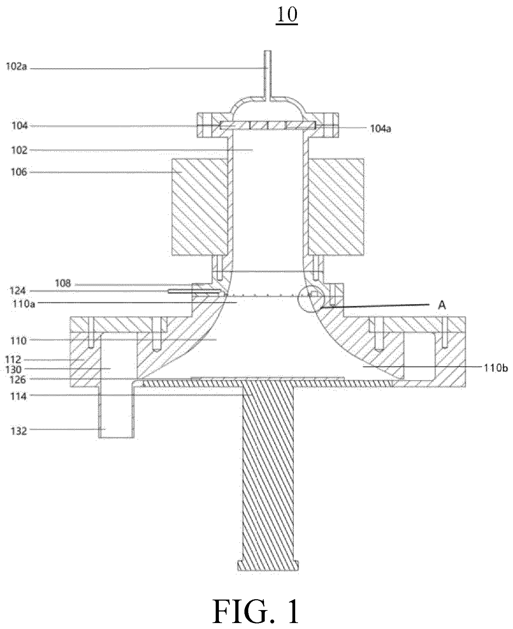

FIG. 1 is a schematic structural diagram of an atomic layer deposition device according to an embodiment of this application.

As shown in FIG. 1, an atomic layer deposition device 10 includes a transition chamber 102, a spray component 104, a plasma generation device 106, a ring-shaped source feeding structure 108, a diffusion chamber 110, an ring-shaped air exhaust structure 112, and a wafer support platform 114.

The transition chamber 102 has an air inlet 102a to receive a gas. The gas may be a process gas or a non-process gas.

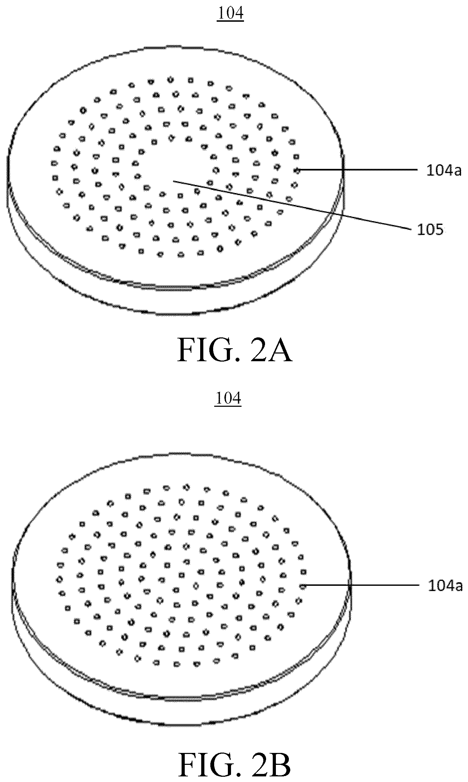

The spray component 104 is disposed in the transition chamber 102, and includes a plurality of diffusion holes 104a. FIG. 2A to FIG. 2B are schematic structural diagrams of two spray components 104according to an embodiment of this application. As shown in FIG. 1 and FIG. 2A to FIG. 2B, the diffusion holes 104a are uniformly distributed on the spray component 104. The only difference between FIG. 2A and FIG. 2B is that no diffusion holes 104a are distributed in a central region part 105 in FIG. 2A. The spray component 104 having uniformly distributed diffusion holes 104a is arranged in the transition chamber 102, so that the gas entering from the air inlet 102a may uniformly enter the transition chamber 102, thereby facilitating uniform distribution of compositions in the chamber and uniformity of deposition. It is to be understood that the spray component104 having uniformly distributed diffusion holes 104a is merely a preferred embodiment of this application. In another embodiment of this application, the diffusion holes 104a may not necessarily be uniformly distributed on the spray component 104.

The plasma generation device 106 is disposed onan outer periphery of the transition chamber 102. In an embodiment of this application, the plasma generation device 106 may be a radio frequency coil. The radio frequency coil may surround the outer periphery of the transitionchamber102. After a high-frequency current is passed into the radio frequency coil, the process gas passing through the spray component 104 may be excited into plasma. In another embodiment of this application, the plasma generation device 106 may also be a remote plasma source.

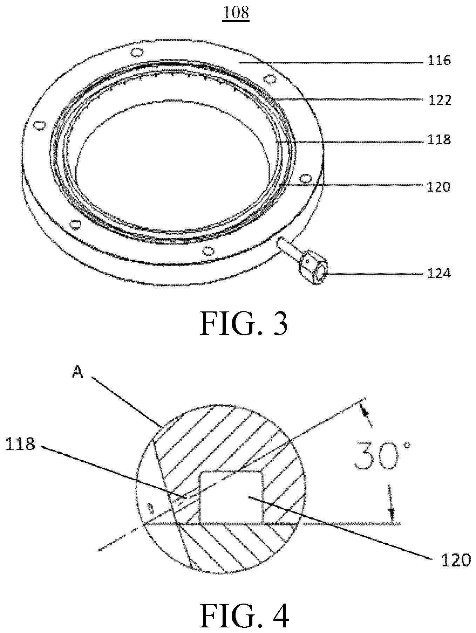

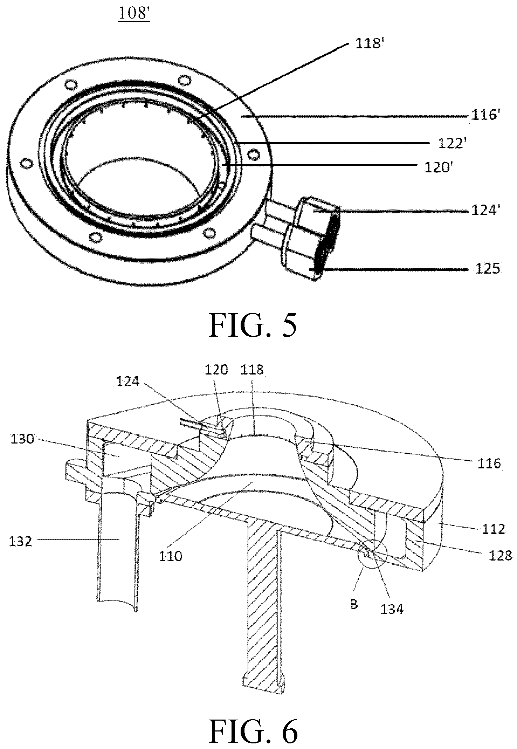

The ring-shaped source feeding structure 108 is disposed between the transition chamber 102 and the diffusion chamber 110. FIG. 3 is a schematic structural diagram of a ring-shaped source feeding structure according to an embodiment of this application. As shown in FIG. 1 and FIG. 3, the ring-shaped source feeding structure 108 includes a ring-shaped body 116, a source feeding hole 118, a ring-shaped groove 120, a seal groove 122, and an air intake duct 124. A plurality of source feeding holes 118 are provided, are circumferentially distributed on an inner surface of the ring-shaped body 116, and are in communication with the diffusion chamber 110. The circumferentially uniformly distributed source feeding holes 118 may ensure uniform distribution of precursors in the diffusion chamber 110. In some embodiments of this application, a quantity of source feeding holes 118 is in a range of 4 to 40, and the pore size of each source feeding hole 118 is in a range of 1 mm to 2 mm. FIG. 4 is an enlarged schematic diagram of a structure A shown in FIG. 1. As shown in FIG. 4, in an embodiment of this application, an included angle between the source feeding hole 118 and a horizontal plane is 30°. In some other embodiments of this application, the included angle between the source feeding hole 118 and the horizontal plane may further be in a range of 0° to 30°. Through specifically settings of the quantity and the pore sizes of the source feeding holes 118 and the included angle between each of the source feeding holes and the horizontal plane, the atomic layer deposition device 10 provided in the embodiments of this application may produce a better effect of uniform diffusion of precursors, thereby further facilitating uniform distribution of compositions in the cavity and uniformity of deposition. An ring-shaped groove 120 is provided on an ring-shaped body 116, and is in communication with the source feeding hole 118. The ring-shaped groove 120 may ensure that the precursors enter a diffusion chamber 110 along the source feeding hole 118. A seal groove 122 is provided on the ring-shaped body 116. A sealing ring (not shown) is arranged inside the sealing groove 122, to ensure that the precursors in the ring-shaped groove 120 do not diffuse to the outside. In another embodiment of this application, the sealing ring may be an O-shaped ring. An air intake duct 124 is disposed on the ring-shaped body 116 and extends into the ring-shaped groove 120. The air intake duct 124 is configured to receive the precursor and a carrier gas. FIG. 5 is a schematic structural diagram of another ring-shaped source feeding structure according to an embodiment of this application. As shown in FIG. 5, a ring-shaped source feeding structure 108' includes an ring-shaped body 116', a source feeding hole 118', a ring-shaped groove 120', a sealing groove 122', and air intake ducts 124' and 125. A structure of the ring-shaped source feeding structure 108' is substantially similar to the structure of the ring-shaped source feeding structure 108 shown in FIG. 3, and a difference is that the ring-shaped source feeding structure 108' has the two air intake ducts 124' and 125. The arrangement of the two air intake ducts and compositions from a transition chamber 102 not only may realize an A+B reaction mode that may be achieved during use of a single air intake duct, but also may realize a reaction mode such as A+B+C, (A+B)+(A+C), or A+(B+C).

A diffusion chamber 110 is in communication with the transition chamber 102, and is configured to accommodate a to-be-deposited semiconductor wafer 126. The diffusion chamber 110 extends from a first end portion 110a to a second end 110b, and a width of the first end 110a is less than a width of the second end 110b in a radial direction. The diffusion chamber 110 of such a structure may facilitate uniform diffusion of compositions in the diffusion chamber 110. Through communication with the source feeding hole 118 of the ring-shaped source feeding structure 108 at the first end 110a, the diffusion cavity 110 may receive a carrier gas and a precursor from the ring-shapedsource feeding structure 108. In an embodiment of this application, as shown in FIG. 1, the diffusion chamber 110 adopts a trumped-shaped structure design. The trumped-shaped structure design may further facilitate the uniform diffusion of compositions in the diffusion chamber 110, and may further facilitate quick replacement of compositions inside the diffusion chamber 110 (that is, excessive reactants in the diffusion chamber 110 are quickly sucked out of the chamber). More specifically, a curvilinear structure with a horn edge has impact on a gas flow field. A smooth horn edge structure facilitates smooth flow of the gas in the diffusion chamber 110. The gas and the reactants in the diffusion chamber 110 may be allowed to enter the diffusion chamber 110 in an orderly manner in a queue, or are sucked out of the diffusion cavity 110 in an orderly manner. However, in another embodiment of this application, the diffusion chamber 110 may be in another structural form, for example, a trapezoidal structure or a dome-like structure.

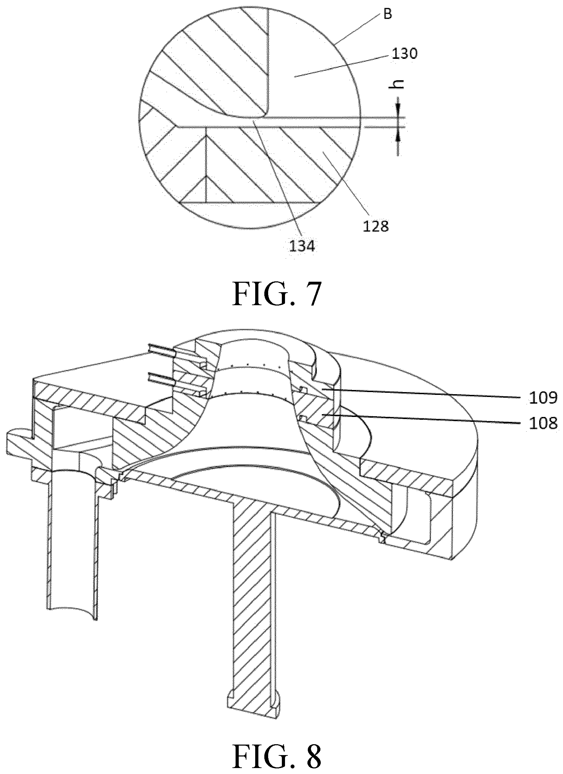

The ring-shaped air exhaust structure 112 is disposed surrounding the diffusion chamber 110, and is in communication with the diffusion chamber 110. FIG. 6 is a schematic cross-sectional view of a partial structure of the atomic layer deposition device shown in FIG. 1. Referring to FIG. 1 and FIG. 6, the ring-shaped air suction structure 112 includes a ring-shaped body 128, a ring-shaped air exhaust channel 130, and an air exhaust pipeline 132. The ring-shaped air exhaust channel 130 is disposed on the ring-shaped body 128, to form a ring-shaped air exhaust passage. FIG. 7 is an enlarged schematic diagram of a structure B shown in FIG. 6. Referring to FIG. 6 and FIG. 7, a slit 134 is provided between ring-shaped air exhaust channel 130 and the diffusion chamber 110. In an embodiment of this application, the slit 134 has the height h. In an embodiment of this application, the height h of the slit 134 may be in a range of 1 mm to 3 mm. However, it is to be understood that, in another embodiment of this application, the height h of the slit 134 may also be another numerical value, which is not specifically limited herein. The slit 134 is used for bringing the ring-shaped air exhaust channel 130 of the ring-shaped air exhaust structure 112 into communication with the diffusion chamber 110, so as to suck out compositions in the diffusion chamber 110. The air exhaust pipeline 132 is disposed on the ring-shaped body 128 and extends to the ring-shaped air exhaust channel 130. The compositions in the diffusion chamber 110 may be sucked out through the slit 134, the ring-shaped air exhaust channel 130, and the air exhaust pipeline 132 in sequence. The air exhaust pipeline 132 may be further connected to an external exhaust component (not shown), to achieve vacuum air suction. In an embodiment of this application, an equivalent diameter of the ring-shaped air exhaust channel 130 may be in a range of 20 mm to 100 mm. However, it is to be understood that, in another embodiment of this application, the equivalent diameter of the ring-shaped air exhaust channel 130 may also be another numerical value, which is not specifically limited herein.

A wafer support platform 114 is configured to support a to-be-deposited semiconductor wafer 126. The wafer support platform 114 may have a heating member (not shown), to heat the semiconductor wafer 126 carried on the wafer support platform 114.

FIG. 8 is a schematic cross-sectional view of a partial structure of an atomic layer deposition device having two ring-shaped source feeding structures. As shown in FIG. 8, in another embodiment of this application, an atomic layer deposition device may include two ring-shaped source feeding structures, namely, a ring-shaped source feeding structure 108 and a ring-shaped source feeding structure 109. The ring-shaped source feeding structure 109 is disposed on the ring-shaped source feeding structure 108. A structure of the ring-shaped source inlet structure 109 is the same as a structure of the ring-shaped source feeding structure 108, and details are not described herein again. The arrangement of the two ring-shaped source feeding structures and compositions from a transition chamber102 not only may realize an A+B reaction mode that may be achieved during use of a single ring-shaped source feeding structure, but also may realize a reaction mode such as A+B+C, (A+B)+(A+C), or A+(B+C).

FIG. 1 is used as an example. When atomic layer deposition is performed by using the atomic layer deposition device 10 provided in the embodiments of this application, it is first ensured that a carrier gas is always stably and continuously passed into the diffusion chamber 110 through an air intake duct 124 of the ring-shaped source feeding structure 108 during a cycle. When the deposition is started, the carrier gas and precursors are passed through the air intake duct 124 of the ring-shaped source feeding structure 108. The precursors uniformly enter the diffusion chamber 110 with the carrier gas. In this case, the non-process gas from the air inlet 102a of the transition chamber 102 is passed into a top of the transition chamber102 through the spray component 104, and then quickly and uniformly diffuses to a surface of the semiconductor wafer 126, thereby achieving saturation adsorption of the surface of the semiconductor wafer 126. Next, the precursors are turned off, and the carrier gas from the air intake duct 124 of the ring-shaped source feeding structure 108 and the non-process gas above the transition chamber102 are continuously passed into the diffusion chamber 110 until unreacted precursors are completely blown away. Subsequently, the non-process gas is turned off, and the process gas is passed through the air inlet 102a of the transition chamber102 (this operation may ensure stability of an air pressure in the chamber). The process gas may further uniformly enter the transition chamber 102 through the spray component 104 in the transition chamber 102, and the remote plasma source or the radio frequency coil is enabled at the same time, so that the process gas is in an excited state with relatively high activation energy. With flow of the gas, the process gas in the excited state may uniformly reach the surface of the semiconductor wafer 126 through the trumpet-shaped diffusion chamber110, and react with the precursors on the surface of the semiconductor wafer 126. Finally, the process gas and the remote plasma source or the radio frequency coil are turned off, and the non-process gas is passed (this operation may ensure the stability of the air pressure in the chamber), until excessive process gas is completely blown away by the carrier gas. In this way, a layer of deposition is achieved. The foregoing steps are repeated 1-4 times to achieve atomic layer deposition.

The atomic layer deposition device provided in the embodiments of this application has at least the following advantages: 1. The process gas may uniformly enter the transition chamber, thereby facilitating the uniform distribution of the compositions in the chamber and the uniformity of deposition. 2. The carrier gas may carry the precursors uniformly into the diffusion chamber, so that the precursors may quickly and uniformly diffuse to the surface of the semiconductor wafer. 3. The improvement of the shape and the structure of the diffusion chamber facilitates the uniform distribution of the compositions in the diffusion chamber, and may further facilitate quick replacement of the compositions inside the diffusion chamber. 4. The ring-shaped air exhaust structure improves fluidity of the gas on the surface of the semiconductor wafer in a horizontal direction, further ensures consistency of compositions on the surface of the semiconductor wafer, and effectively improves uniformity of deposited thin films. 5. Compared with the prior art, in the embodiments of this application, through the arrangement of the ring-shaped air exhaust structure, a conventional air exhaust method is changed, and a bottom space of the atomic layer deposition device is saved.

Compared with the prior art, the atomic layer deposition device provided in the embodiments of this application adopts a special chamber structure and source feeding manner, which facilitates the replacement of the gas in the chamber, reduces a cycle time of each cycle, and improves the deposition efficiency.

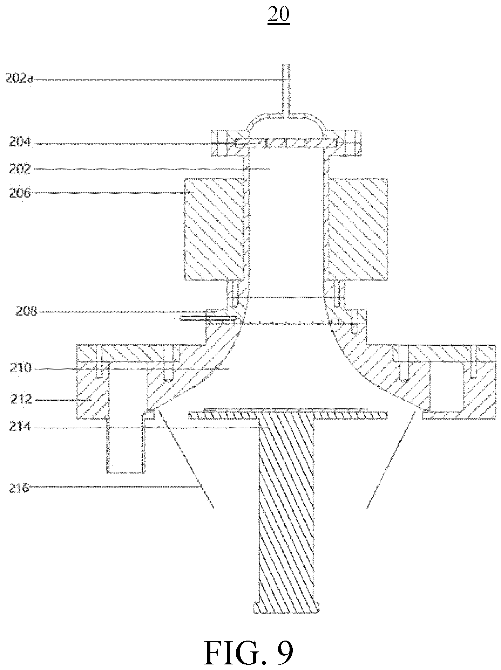

FIG. 9 is a schematic structural diagram of another atomic layer deposition device according to an embodiment of this application. As shown in FIG. 9, an atomic layer deposition device 20 includes a transition chamber 202, a spray component 204, a plasma generation device 206, a ring-shaped source feeding structure 208, a diffusion chamber 210, a ring-shaped air exhaust structure 212, and a wafer supporting platform 214. A main structure of the atomic layer deposition device 20 is the same as that of the atomic layer deposition device 10 shown in FIG. 1, and an only difference is that the atomic layer deposition device 20 further includes a bottom air exhaust structure 216. The bottom air exhaust structure 216 is disposed at the bottom of the diffusion chamber 210. The bottom air exhaust structure 216 may be connected to an external suction component (not shown), to achieve vacuum air suction. In FIG. 9, the bottom air exhaust structure 216 is in the form of a bottom air exhaust channel. However, in some other embodiments of this application, the bottom air exhaust structure 216 may further be in another structural form, as long as the vacuum air exhaust can be achieved. Through arrangement of both the ring-shaped air exhaust structure 212 and the air exhaust channel 216, fluidity of a gas on a surface of a semiconductor wafer in a horizontal direction in a single air suction mode may be further improved, consistency of compositions on the surface of the semiconductor wafer may be further ensured, and uniformity of deposited thin films may be further improved. In addition, through a combination of two air suction modes, an air suction rate may be increased, a deposition time may be reduced, and a deposition rate may be further increased.

In addition, in some embodiments of this application, only the bottom air exhaust structure 216 may be arranged without the ring-shaped air exhaust structure 212. Such a structure can also ensure the consistency of the compositions on the surface of the semiconductor wafer, and improve the uniformity of the deposited thin films.

It is to be noted that reference to "an embodiment of this application" or similar terms throughout this specification means that specific features, structures, or characteristics described together with other embodiments are included in at least one embodiment and may not necessarily be present in all of the embodiments. Therefore, corresponding occurrences of the phrase "an embodiment of this application" or the similar terms throughout this specification may not necessarily refer to the same embodiment. In addition, the specific features, structures, or characteristics of any specific embodiment may be combined with one or more other embodiments in any proper manner.

The technical content and technical features of the present invention have been disclosed above. However, a person skilled in the art may still make various substitutions and modifications based on the teachings and disclosures of the present invention without departing from the spirit of the present invention. Therefore, the protection scope of the present invention should not be limited to the content disclosed in the embodiments, but should include various substitutions and modifications without departing from the present invention and are covered by the claims of this patent application.

## Claims

1. An atomic layer deposition device, comprising:
a transition chamber, having an air inlet to receive a gas;
a diffusion chamber, extending from a first end to a second end, wherein a width of the first end being less than a width of the second end in a radial direction, and the diffusion chamber being in communication with the transition chamber and being configured to accommodate a to-be-deposited semiconductor wafer; and
one or more air exhaust structures, in communication with the diffusion chamber.

2. The atomic layer deposition device according to claim 1, wherein the diffusion chamber comprises one of a trumpet-shaped structure, a trapezoidal structure, or a dome-shaped structure.

3. The atomic layer deposition device according to claim 1, wherein the one or more air exhaust structures comprise a ring-shaped air exhaust structure surrounding the diffusion chamber and in communication with the diffusion chamber, the ring-shaped air exhaust structure comprising:
a ring-shaped body;
a ring-shaped air exhaust channel, disposed on the ring-shaped body; and
an air exhaust pipeline disposed on the ring-shaped body and extending to the ring-shaped air exhaust channel.

4. The atomic layer deposition device according to claim 3, wherein a slit is provided between the ring-shaped air exhaust channel and the diffusion chamber, to bring the ring-shaped air exhaust structure into communication with the diffusion chamber.

5. The atomic layer deposition device according to claim 1 or 3, wherein the one or more air exhaust structures comprise a bottom air exhaust structure, disposed at a bottom of the diffusion chamber.

6. The atomic layer deposition device according to claim 1, further comprising:
a spray component, disposed in the transition chamber, and comprising a plurality of diffusion holes.

7. The atomic layer deposition device according to claim 6, wherein the plurality of diffusion holes are uniformly distributed on a surface of the spray component.

8. The atomic layer deposition device according to claim 6, wherein the plurality of diffusion holes are uniformly distributed on a surface of the spray component other than a central region part.

9. The atomic layer deposition device according to claim 1, further comprising:
a plasma generation device, disposed on an outer periphery of the transition chamber.

10. The atomic layer deposition device according to claim 1, further comprising one or more ring-shaped source feeding structures, disposed between the transition chamber and the diffusion chamber, wherein the one or more ring-shaped source feeding structures comprises:
a ring-shaped body;
a plurality of source feeding holes, circumferentially distributed on an inner surface of the ring-shaped body;
a ring-shaped groove, disposed on the ring-shaped body and in communication with the plurality of source feeding holes; and
one or more air intake ducts, disposed on the ring-shaped body and extending into the ring-shaped groove.

11. The atomic layer deposition device according to claim 10, wherein the one or more ring-shaped source feeding structures further comprise a sealing groove disposed on the ring-shaped body and a sealing ring disposed in the sealing groove.

12. The atomic layer deposition device according to claim 10, wherein an included angle between each of the plurality of source feeding holes and a horizontal plane is in a range of 0° to 30°.

13. The atomic layer deposition device according to claim 1, further comprising a wafer support platform, disposed in the diffusion chamber and configured to support the semiconductor wafer.
